(19) Europäisches Patentamt
European Patent Office
Office européen des brevets

(11) Publication number: 0 000 829
B1

(12) **EUROPEAN PATENT SPECIFICATION**

(45) Date of publication of patent specification: 06.01.82

(51) Int. Cl.³: H 01 L 31/06, H 01 L 29/28 //H01L31/02

(21) Application number: 78300233.0

(22) Date of filing: 02.08.78

# (54) Photovoltaic elements.

(30) Priority: 02.08.77 US 821115

(43) Date of publication of application: 21.02.79 Bulletin 79/4

(45) Publication of the grant of the European patent: 06.01.82 Bulletin 82/1

(84) Designated Contracting States: DE FR GB

(73) Proprietor: EASTMAN KODAK COMPANY
343 State Street
Rochester, New York 14650 (US)

(72) Inventor: Tang, Ching Wan
138 Falmouth Street
Rochester New York (US)

(74) Representative: Trangmar, Leigh Alan
P.O. Box 114 246 High Holborn
London WC1V 7EA (GB)

(56) References cited:
FR - A - 2 321 769
US - A - 3 057 947
US - A - 3 379 742
US - A - 3 403 165
US - A - 3 814 600
US - A - 3 992 205

JOURNAL OF HETEROCYCLIC CHEMISTRY vol. 9, October 1972 (US) Provo
G. A. REYNOLDS and J. A. VAN ALLAN: "The reactions of pyramylidene methylpyrylium salts with sodium sulfide" page 1105—1107

(56) References cited:
RESEARCH DISCLOSURE vol. 162, October 1977 Homewell, Havant, Hampshire
CHING WAN TANG: "Multilayer organic photovoltaic element", page 71—73

EP 0 000 829 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Photovoltaic elements

This invention relates to photovoltaic elements useful for converting light into electrical energy.

Schottky barrier and P—N junction photocells rely upon the fact that a built-in-potential exists at the metal/semiconductor interface as in the Schottky device or at the junction between the P-type and N-type semiconductors as in the P—N junction device.

Inorganic semiconductors have been used in the past for solar cells because of their fairly high conversion efficiencies which have been as high as 12 to 15 percent. However, such cells have proven to be very expensive to construct because of the melt and other processing techniques necessary to fabricate the semiconductor layer. As a result, such cells have had extensive practical utility only in the field of space exploration, and not in terrestrial applications.

In an effort to reduce the cost of solar cells, organic photoconductors and semiconductors have been considered, because of the inexpensive formation of the photoconductive layer by solvent coating and similar techniques.

Phthalocyanine has been used in organic solar cells in the past in contact with a layer containing an electron acceptor such as oxidized tetramethyl *p*-phenylenediamine, *β*-carotene, dibrominated *p*-phenylenediamine and *p*-chloranil. An example is described in U.S. Patent 3,057,947 in which a layer of compressed magnesium phthalocyanine 1 mm (1000 microns) thick is coated with a layer of air-oxidised tetramethyl-*p*-phenylene-diamine. It is assumed that there exists a rectifying junction between these layers. Electrodes, one of them transparent, are placed in contact with each layer. Such photovoltaic cells have thick layers, very high internal resistance and very low power outputs.

Multilayer photoelectric cells have been constructed from a layer comprising a phthalocyanine dispersed in an organic polymeric binder with or without an overcoat of malachite green, as reported, for example, in *Topics in Current Chemistry,* Springer-Verlag, Volume 61, 1976, page 124, and U.S. Patent 3,789,216, issued January 29, 1974. However, the conversion efficiency of such cells was very low — less than $10^{-4}$ percent, as reported in Springer-Verlag.

A layer of porphyrin has been used to improve certain inorganic photovoltaic cells e.g., selenium cells. Examples are disclosed in U.S. Patent 3,935,031. However, only expensive inorganic semiconductors which themselves are self-sufficient cell materials have been suggested for such use with porphyrin.

According to the present invention there is provided a photovoltaic element which comprises

(1) a first layer comprising an organic electron donor compound, in contact with
(2) a second layer comprising an organic electron acceptor compound,

said layers forming a rectifying junction between them and at least one of said layers being capable of absorbing radiation at wavelengths between 350 and 1000 nm, and

(3) an electrode in operative ohmic contact with each of said layers, at least one of said electrodes being transparent to electromagnetic radiation to which the photovoltaic element is sensitive.

characterised in that the organic compound of each of layers (1) and (2) has a molecule having a planar polycyclic nucleus and wherein the combined thickness of the electron donor compound layer or layers and the electron acceptor compound layer or layers is no greater than 0.5 micron.

In a preferred embodiment of the invention each of said organic compounds has a molecule whose surface area is at least 0.4 $nm^2$ and a width of at least 0.5 nm.

In another preferred embodiment of the invention the electron acceptor has a molecule containing a nucleus having at least 7 fused carbocyclic and/or heterocyclic rings and the electron donor has a molecule containing a nucleus having at least 8 fused carbocyclic and/or heterocyclic rings.

The surface area of the molecule is calculated by assuming the atoms are points connected by a bond of appropriate length, i.e. 0.139 nm in a benzene ring. Hence the surface area of benzene is 0.05 $nm^2$. However, where the molecule is not annulated, that is where the rings are joined together in a non-rigid manner, e.g. by a single bond, the effective area is greater than the area as calculated above. In such a case, it is the effective area which should be taken and this will normally be some 30% greater than the calculated area.

In another embodiment of the invention the electron donor is a porphyrin or phthalocyanine and the electron acceptor is a photoconductive organic dye capable of absorbing radiation at wavelengths between 350 and 1000 nm.

As used in the present specification and claims photovoltaic element means a solid state device which converts radiation absorbed by the element directly to electric power.

Thus the elements of this invention are suitable as terrestrial rooftop generators (solar cells) or as light-level measuring devices. As a light-level measuring device, the element may be used both at high and low light levels. The elements exhibit moderately high open circuit voltages of from 300—500 mV.

Alternatively, the element may also be used in the current mode. The current generated in a

diffuse room-light condition is about 20 $\mu A/cm^2$, a large enough current to be measured accurately. The current can thus become a measure of the light intensity, and the cell can be used as an exposure meter.

The photovoltaic elements of the present invention are capable of working at conversion efficiencies of at least 0.02% and, for example, as high as 1%.

The terms "electron donor" and "electron acceptor" used in the present specification and claims are used to describe the respective electron affinity of the compounds when layers comprising them are in contact with each other. Thus, an electron donor has a relatively low electron affinity, and an electron acceptor has a relatively high electron affinity. As such, an electron donor tends to act as a p-type semi-conductor whereas an electron acceptor tends to act as an n-type semi-conductor.

As used in the present specification and claims the term "rectifying junction" means a junction which provides a ratio of forward current to reverse current of at least 10 when a potential of at least 0.5 V is applied to the element.

"Polycyclic" is used in the present specification and claims to mean containing two or more rings which may be fused or not.

By the term "planar" used in the present specification and claims we mean that the atoms of the nucleus lie in the same plane or that any atom of the nucleus or a resonance form thereof lies no more than 10° out of the plane.

The photovoltaic elements made from coatings of the above compounds will be generally free from short circuits between the electrodes due to pinholes in the coatings. The compounds, when coated, appear to deposit as flat, overlying molecules. Also, the planarity of the compounds' nuclei provides minimum resistance to charge transport through their layers and therefore provides a maximum short circuit current.

In one preferred embodiment of the invention, the planar polycyclic nuclei of the compounds are highly conjugated, have pi-electrons and have a large surface area. Generally, the larger the molecular surface area of such compounds, the more likely it is that the compounds will provide an element with high conversion efficiencies. It is believed that this greater area provides greater assurance of molecular overlap hence less likelihood of pinhole shorts.

Examples of useful electron donor compounds with planar, fused polycyclic nuclei are the porphyrin and phthalocyanine compounds. Any such compound is operative, with or without a chelated metal atom. The chelated metal, if present, may be cobalt, magnesium, zinc, palladium, nickel, copper, lead, or platinum. Such metal phthalocyanines are preferred for this invention because of the greater conversion efficiencies which they confer on the element. Examples of preferred metal phthalocyanines include copper, lead and platinum phthalocyanine. Lead phthalocyanine has been used to produce an efficient cell with a spectral response extending to almost 1000 nm. It is preferred that an electron donor layer containing a porphyrin be structureless or micro-crystalline, because large crystals in such a layer tend to provide a shorting path which can decrease the efficiency of the element.

As used herein, the term "porphyrin or phthalocyanine compound" means any compound, natural or synthetic, which contains the basic porphyrin or phthalocyanine structure. Examples of such porphyrins are disclosed in the aforesaid U.S. Patent 3,935,031. A preferred class of such compounds are those having the formula:

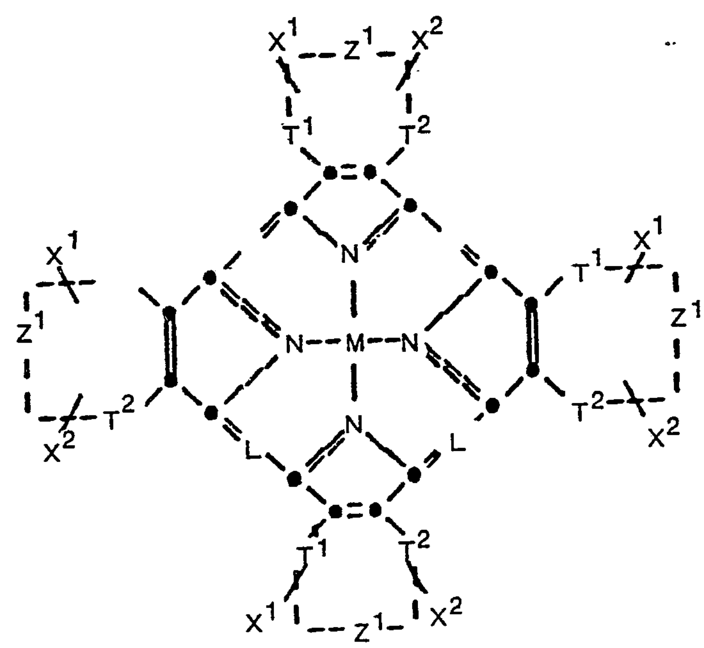

IV

wherein

L is CH or N,

M is a metal,

$T^1$ and $T^2$ are both S or both CH, or one of $T^1$ and $T^2$ is N and the other CH,

$X^1$ and $X^2$ are the same or different, and are each halogen or hydrogen; and

$Z^1$ represent the atoms necessary to complete an unsaturated ring having 6 ring atoms.

One further option is to use compounds of Formula IV, but in a nonmetallic form, wherein two of the four nitrogen atoms associated with M are hydrogenated.

If desired, two electron donor layers of the same or different electron donor compounds may be used. Only one of these layers contacts the electron acceptor layer, while the other is in ohmic contact with an electrode.

Other useful compounds for the electron donor layer are compounds which contain at least 8 carbocyclic and/or heterocyclic fused rings. Examples include ovalene, diindeno [1,2,3-cd-1'2'3'-lm]perylene, violanthrene, isoviolanthrene, and pyranthrene.

Perylene derivatives which are particularly useful as electron acceptor compounds have the formula:

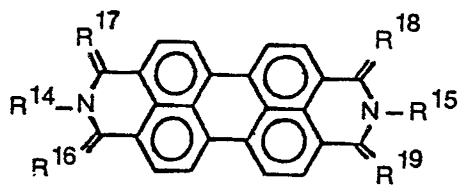

II

wherein

$R^{14}$ and $R^{15}$ are each hydrogen or an alkyl of 1—5 carbon atoms which may be substituted, or a phenyl, substituted phenyl or quinolyl group, and

$R^{16}$, $R^{17}$, $R^{18}$ and $R^{19}$ are each oxygen, or $R^{14}$ and one of $R^{16}$ and $R^{17}$ and/or $R^{15}$ and one of $R^{18}$ and $R^{19}$ together complete a one or two ringed heterocyclic group, in which case the other of $R^{16}$ and $R^{17}$ and/or the other of $R^{18}$ and $R^{19}$ are oxygen.

Examples of compounds of formula II are:

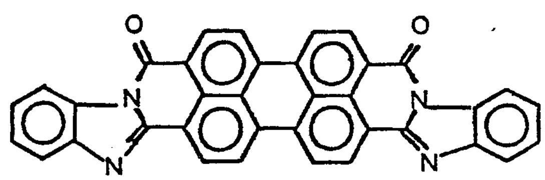

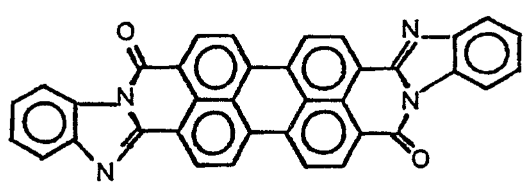

and, preferably

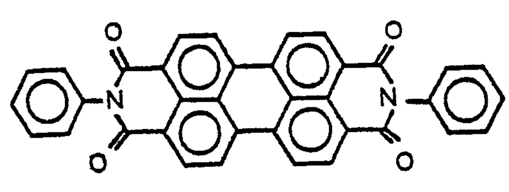

The electron acceptor compound may comprise 7—14 fused carbocyclic and/or heterocyclic rings which may be substituted with one or more electron withdrawing groups such as keto; cyano; halogen, e.g. chlorine or bromine; sulphonyl; carboxy, nitro; imino; alkyl or alkoxy containing from 1 to 5 carbon atoms, for example, methyl, ethyl, propyl; hydroxyl; amino; aryl containing from 6 to 10 carbon ring atoms which may be substituted e.g., phenyl, naphthyl or halo-, alkyl- or alkoxyphenyl; provided that the compound contains at least one electron-withdrawing group.

Representative examples of fused polycyclic compounds of this type are anthraquinone-derived vat dyes such as flavanthrone and derivatives of perylene, coronone-imide, ovalene and compounds of the structure:

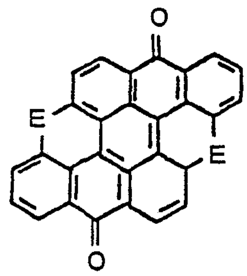

where E is O or S.

Other polycyclic compounds which may be used in electron acceptor layers include those in which the polycyclic rings are not fused. Particularly useful examples are photoconductive organic dyes such as pyrylium-type dye salts which include pyrylium, thiapyrylium and selenapyrylium dye salts, and also salts of the aforementioned pyrylium-type dye salts containing condensed ring systems such as salts of benzopyrylium and naphthopyrylium dyes. Highly preferred examples have a molecule having a surface area of at least 0.4 $nm^2$ and a width in the plane of the compound of at least 0.5 nm.

Examples of pyrylium-type dyes, which may be used are those with the formula:

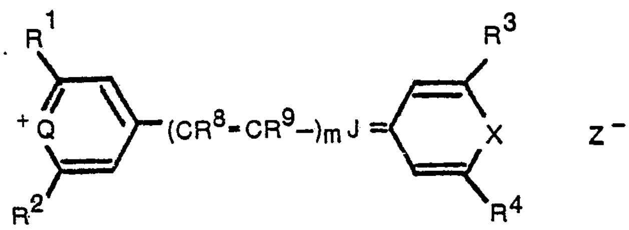

(I)

wherein

J is $CR^{10}$ or nitrogen,

Q and X are each oxygen, sulphur or selenium,

$R^8$, $R^9$ and $R^{10}$ are each hydrogen, an alkyl of 1—3 carbon atoms, an aryl, substituted aryl, cyano or nitro group,

$R^1$, $R^2$, $R^3$ and $R^4$ are each a phenyl or substituted phenyl group or an alkyl or alkoxy group of 1—5 carbon atoms, at least two of $R^1$, $R^2$, $R^3$ and $R^4$ being phenyl or substituted phenyl,

m is 0 or 1 and is 0 if J is nitrogen, and

$Z^-$ is an anion.

Examples of anions $Z^-$ are perchlorate and fluoroborate.

If $R^1$, $R^2$, $R^3$ or $R^4$ are substituted phenyl, it is preferred that the substituents be located in the para position and be selected from those which shift the blue absorption peak of the dye salt to a longer wavelength. Examples of such substituents include alkyl having from 1 to 3 carbon atoms and halogens e.g. chlorine or fluorine.

Another class of useful polycyclic compounds of the unfused type includes 2,4,6-trisubstituted pyrylium, thiapyrylium and selenapyrylium dye salts of the general structure:

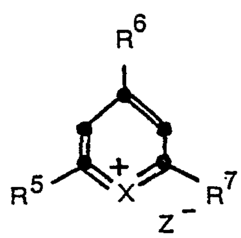

V

in which

$R^5$ and $R^7$ are the same or different and are each alkyl from 1 to 6 carbon atoms, e.g., methyl, ethyl or isopropyl; phenyl, substituted phenyl or a 5 or 6 membered heterocyclic ring, e.g., thienyl, furyl, pyridyl, pyrimidinyl, thadiazolyl, thiazolyl or pyrrolyl.

$R^6$ represents an alkylamino- or dialkylamino-substituted 5 or 6 membered heterocyclic ring having from 1 to 6 carbon atoms in the or each alkyl moiety including dialkylamino-substituted and halogenated alkylamino-substituted phenyl, dialkylaminopyridyl, dialkylaminofuryl, dialkylaminothienyl, dialkylaminopyrimidinyl, dialkylaminothiadiazolyl or dialkylaminothiazolyl;

X is oxygen, selenium or sulphur and

$Z^-$ is an anion, e.g., perchlorate or fluoroborate.

Examples of such compounds, particularly wherein at least one of $R^5$, $R^6$ and $R^7$ is heterocyclic, are described in *Research Disclosure,* Volume 157, May 1977, Publication No. 15742, published by Industrial Opportunities, Ltd., Homewell, Havant, Hampshire, PO9 1EF, United Kingdom.

Examples of pyrylium-type dyes which may be employed as the electron acceptor include:

4-[(2,6-diphenyl-4H-thiapyran-4-ylidene)methyl]-2,6-diphenylthiapyrylium perchlorate,
4-[(2,6-dimethoxy-4H-thiapyran-4-ylidene)methyl]-2,6-diphenylthiapyrylium perchlorate,
4-[(2,6-diphenyl-4H-pyran-4-ylidene)methyl]-2,6-diphenylthiapyrylium perchlorate,
4-[(2,6-diphenyl-4H-pyran-4-ylidene)methyl]-2,6-diphenylpyrylium fluoroborate,
4-[(2,6-diphenyl-4H-thiapyran-4-ylidene)methyl]-2,6-diphenylselenapyrylium perchlorate,
4-[(2,6-diphenyl-4H-selenin-4-ylidene)methyl]-2,6-diphenylselenapyrylium perchlorate,
4-[(2,6-diphenyl-4H-pyran-4-ylidene)methyl]-2,6-diphenylselenapyrylium perchlorate,
4-[(2,6-diethyl-4H-thiapyran-4-ylidene)methyl]-2,6-diphenylthiapyrylium perchlorate,
4-[(2,6-diphenyl-4H-thiapyran-4-ylidene)methyl]-2,6-diethoxythiapyrylium perchlorate,
2,6-diphenyl-4-[(2,6-diphenyl-4H-pyranylidene)amino] pyrylium perchlorate,
2,6-diphenyl-4-(4-dimethylaminophenyl)thiapyrylium hexafluorophosphate,
2,6-diphenyl-4-(4-diphenylaminophenyl)thiapyrylium perchlorate,
2,6-diphenyl-4-(4-dipropylaminophenyl)thiapyrylium perchlorate,
4-{[2,6-di(*p*-methylphenyl)-4H-thiapyran-4-ylidene]methyl}-2,6-diphenylthiapyrylium perchlorate,
4-{[2,6-di-(*p*-fluorophenyl)-4H-thiapyran-4-ylidene]methyl}-2,6-diphenylthiapyrylium perchlorate,
4 - {[2,6 - di(*p* - fluorophenyl) - 4H - thiapyran - 4 - ylidene]methyl} - 2,6 - di(*p* - fluorophenyl)thiapyrylium perchlorate,
4 - {[2,6 - di(*p* - methylphenyl) - 4H - thiapyran - 4 - ylidene]methyl} - 2,6 - di(*p* - methylphenyl)-thiapyrylium perchlorate.

The electron acceptor layer may comprise a mixture of different dye salts of formula (I), or one or more dye salts of formula (I) with one or more dye salts of formula (V). In some instances synergism has been demonstrated, in that the conversion efficiency of the mixture exceeds that obtainable from using either of the dye salts alone.

More than one electron acceptor layer may be employed. They may comprise different compounds or the same compound as used in the first electron acceptor layer.

The thickness of the combined electron donor and acceptor layers is an important aspect of the photovoltaic elements of the invention. It has been found that efficiencies begin to decrease drastically for a thickness in excess of 0.5 micron. This decrease in efficiency is believed to be caused by decreased penetration of light to the region adjacent the rectifying junction, or by increased electrical resistance within the layers. Minimum thickness for the individual layers appears to be dictated by coating techniques and the minimum that can be used without shorting out. Useful devices of good efficiency have been constructed with thicknesses for each of the two layers as low as 10 nm.

Preferred thicknesses for each of the two layers, for optimum photovoltaic element results, are from 30 to 50 nm. If unequal thicknesses are to be used, it is preferred that the thinner layer be adjacent the transparent electrode to permit the best exposure of the rectifying junction to radiation.

In the present photovoltaic elements the electrodes are in operative ohmic contact, one to the electron donor layer and the other to the electron acceptor layer. Although the preferred construction is one in which the electrodes are in actual physical contact with their respective donor or acceptor layers, this need not alway be the case. For example, the electron donor layer which contributes to the formation of the rectifying junction can be spaced away from its electrode by a second electron donor layer, as indicated above. In addition, an electrode which is operative is one which is connected in a manner that does not short circuit the element.

The electrode adjacent to the electron donor layer preferably has a high work function, while the one adjacent to the electron acceptor layer preferably has a low work function.

It has been found that a preferred electrode adjacent to the electron donor layer is a glass or a transparent film such as poly(ethylene terephthalate) coated with a transparent layer of indium tin oxide, tin oxide or nickel. This electrode not only has a high work function, but is transparent. Examples of such electrodes having a glass support are Nesa and Nesatron glass electrodes manufactured by PPG Industries and having a surface resistivity of about 10 to 50 ohms/square and an optical transmittance of about 80 percent, for visible light. Nesa and Nesatron are trademarks of PPG Industries.

The opposite electrode is preferably a metal with a low work function, such as indium, silver, tin or, aluminium and can be transparent or opaque. Silver is a preferred electrode for minimum loss in conversion efficiency upon aging.

A photovoltaic element according to the present invention is shown in enlarged cross-section in the accompanying drawing and comprises a laminar array 10 of a window electrode 12 comprising a transparent support 14 and a transparent electrically conductive layer 16; an electron donor layer 18, an electron acceptor layer 20 and an electrode 22 of a metal in ohmic contact with layer 20. It will be appreciated that the dimensions of the element in the drawing have been exaggerated for clarity. Preferred thicknesses for the layers comprise, for layer 16, 0.5 micron to 5 microns; for layer 18, 10 to 250 nm; for layer 20, 10 to 250 nm; and for electrode 22, 10 to 200 nm. As noted above, the

combined thicknesses of layers 18 and 20 do not exceed 0.5 micron.

Wires 24 represent leads contacting the electrodes to connect the element to a load circuit.

A preferred technique for making the present photovoltaic elements involves forming the electron donor layer and the electron acceptor layer (forming the rectifying junction) by coating them from two different solvents, one upon the other, the solvent for one being a poor solvent for the other. In this manner, a well-defined interface between the two layers will be maintained. An alternative and highly preferred method is to vapor deposit a porphyrin or phthalocyanine electron donor layer on a clean, i.e. polished, window electrode (using electron donor compounds which are reasonably free of decomposable impurities) and thereafter solvent coat a dye salt electron acceptor layer, for example, by spin coating it at between 1,000 and 10,000 rpm from the solvents 1,2-dichloroethane, dichloromethane or mixtures of the two. For pyrylium dye salts, a particularly useful solvent mixture has been, 49 weight percent 1,2-dichloroethane, 49 weight percent dichloromethane, and 2 weight percent 1,1,1,3,3,3-hexafluoroisopropyl alcohol. This solvent mixture is employed for spin-coating throughout the Examples below. A currently preferred process for polishing the Nesatron glass (which can be used as a window electrode) comprises rubbing the Nesatron glass surface with a cotton flannel wetted with a suspension of an alumina or other abrasive. The polished Nesatron glass is then cleaned in an ultrasonic cleaner containing 1:1 $H_2O$/isopropyl alcohol for about a half an hour to remove the abrasive particles. It can then be rinsed thoroughly with distilled water.

The electrode for the electron acceptor containing the dye salt layer is preferably applied by conventional vapor deposition techniques.

The following Examples are included for a better understanding of the invention. In each case, a slide projector, together with appropriate glass filters and a water filter, was used to provide a simulated 75 mW/cm$^2$ sunlight, as defined in H. J. Hovel, in Semiconductors and Semimetals, Vol. 2, "Solar Cells", 1975. The light incident on the element had an intensity of 75 mW/cm$^2$, calibrated against a standard silicon solar cell having a short-circuit current output of 21.5 mA/cm$^2$ at 75 mW/cm$^2$. The current-voltage characteristics of each element were obtained by applying an external voltage to the element in either polarity. The voltage across the element and the current through it were measured by a multimeter and were simultaneously plotted usiung an x—y recorder. Fill Factor (as defined by Hovel *supra*) is the fraction of the product of the short circuit current and open circuit voltage which is available as power output.

Example 1

An element as shown in the accompanying drawing was fabricated in the following manner:

(a) A piece of Nesatron glass 100 microns thick and about 1 inch square was polished and thoroughly cleaned and was used as the window electrode 12.

(b) A 40 nm thick copper-phthalocyanine film was deposited on the Nesatron glass by vapor deposition in a 1.3 x $10^{-3}$ Pascal vacuum to provide the electron donor layer 18.

(c) A 40 nm thick layer of a photoconductive dye salt, 4-[(2,6-diphenyl-4H-thiapyran-4-ylidene)methyl]-2,6-diphenylthiapyrylium perchlorate, was spin-coated on top of the copper phthalocyanine layer to form the electron acceptor layer 20. This layer 20 appeared to be homogeneous and very uniform.

(d) The top electrode 22, indium, was vapor deposited on top of the two organic layers 16 and 18 to complete the element.

Under the simulated sunlight illumination described above (75 mW/cm$^2$), the element developed an open-circuit voltage of 0.36 volt, a short-circuit current of 2 mA/cm$^2$, and a fill factor of 0.47. The power conversion efficiency was 0.45 percent.

Examples 2 to 7

Layers of dye salts having the formula:

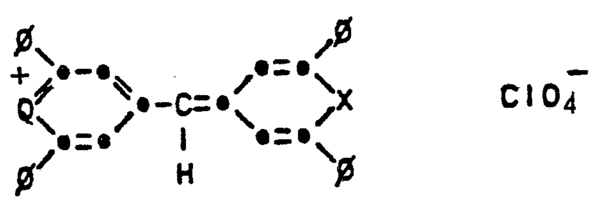

(wherein Ø is phenyl, and X and Q are as defined in Table I below) were tested as electron acceptor layers in elements prepared as described in Example 1. The copper phthalocyanine electron donor layer deposited by vapor deposition was about 40 nm thick, and the dye salt electron acceptor layer deposited on the Cu-phthalocyanine electron donor layer by spin-coating was also about 40 nm thick. Table I lists the photovoltaic output of the elements when tested under the simulated illumination described in Example 1.

TABLE I

| Example | Q | X | Open Circuit Voltage (volts) | Short Circuit Current (mA/cm²) | Conversion Efficiency, % |
|---|---|---|---|---|---|
| 2 | O | O | 0.55 | 0.9 | 0.29 |
| 3 | O | S | 0.45 | 1.6 | 0.43 |
| 4 | S | S | 0.36 | 2.0 | 0.45 |
| 5 | S | Se | 0.31 | 1.5 | 0.28 |
| 6 | Se | Se | 0.24 | 2.0 | 0.28 |
| 7 | O | Se | 0.42 | 0.4 | 0.10 |

Examples 8 to 11

Dye salts having the formula:

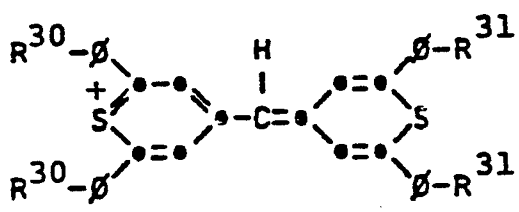 $ClO_4^-$

wherein the $R^{30}$ and $R^{31}$ substituents are *para* and as identified in Table II below were tested as electron acceptor compounds in photovoltaic elements as described in Example 1. Table II lists the output of these elements.

TABLE II

| Example | $R^{30}$ | $R^{31}$ | Open Circuit Voltage (volts) | Short Circuit Current (mA/cm²) | Conversion Efficiency, % |
|---|---|---|---|---|---|
| 8 | H | $CH_3$ | 0.33 | 1.75 | 0.31 |
| 9 | H | F | 0.30 | 2.15 | 0.35 |
| 10 | F | F | 0.20 | 1.6 | 0.17 |
| 11 | $CH_3$ | $CH_3$ | 0.40 | 1.3 | 0.28 |

Examples 12 to 19

Metal-free phthalocyanine and a number of metal-phthalocyanines were tested as electron donor compounds in photovoltaic elements as described in Example 1. Phthalocyanine layers of thickness ranging from 30 to 50 nm were deposited on clean Nesatron glass electrode. Then a 40 to 50 nm thick electron acceptor layer consisted of 4-[(2,6-diphenyl-4H-thiapyran-4-ylidene)methyl]-2,6-diphenylthiapyrylium perchlorate. Table III lists the output of these elements.

TABLE III

| Example | Phthalocyanine | Open Circuit Voltage (volts) | Short Circuit Current (mA/cm$^2$) | Conversion Efficiency, % |
|---|---|---|---|---|
| 12 | Metal-free | 0.25 | 0.18 | 0.02 |
| 13 | Co | 0.20 | 0.35 | 0.03 |
| 14 | Ni | 0.25 | 0.80 | 0.09 |
| 15 | Cu | 0.36 | 2.00 | 0.45 |
| 16 | Zn | 0.36 | 1.10 | 0.14 |
| 17 | Pb | 0.35 | 3.50 | 0.50 |
| 18 | Pd | 0.42 | 0.75 | 0.14 |
| 19 | Pt | 0.38 | 1.25 | 0.21 |

Example 20

A 40 to 50 nm thick Cu-phthalocyanine electron donor layer was deposited on a clean Nesatron glass electrode by vapor deposition. Then a 40 to 50 nm thick layer containing a 1:1 by weight mixture of 4-[(2,6-diphenyl-4H-pyran-4-ylidene)methyl]-2,6-diphenylpyrylium perchlorate and 4-[(2,6-diphenyl-4H-thiapyran-4-ylidene)methyl]-2,6-diphenylthiapyrylium perchlorate, was spin-coated on top of the Cu-phthalocyanine layer to form an electron acceptor layer. Indium was the other electrode. Under artifical illumination, as described in Example 1, the element developed an open-circuit voltage of 0.43 volt, a short-circuit current of 2 mA/cm$^2$, and a fill factor of 0.44, giving an efficiency of 0.5 percent.

Example 21

Example 20 was repeated, except that a 1:1 mixture of 4-[(2,6-diphenyl-4H-thiapyran-4-ylidene)-methyl]-2,6-diphenylthiapyrylium perchlorate and 2,6-diphenyl-4-(4-dimethylaminophenyl)thiapyrylium perchlorate was used to form the electron acceptor layer. The conversion efficiency was found to be about 0.5 percent.

Example 22

An element of the configuration described in Example 1, having a silver electrode instead of indium, developed an open-circuit voltage of 0.38 volt, a short-circuit current of 1.8 mA/cm$^2$ and a fill factor of 0.4, giving a conversion efficiency of 0.36 percent. The element was quite stable under prolonged illumination. After subjecting the element to a 90-hour exposure to the 75 mW/cm$^2$ illumination described above, the element reached an efficiency of 0.23 to 0.25 percent, with no evidence of further degradation.

Example 23

An element was fabricated as described in Example 1, but the dye salt used in step (c) was the following:

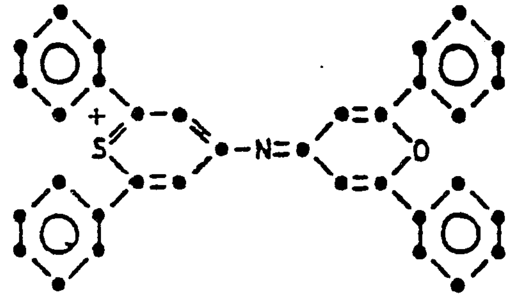

$ClO_4^-$

The element had an open-circuit voltage of 0.5 V, a short-circuit current of 0.2 mA/cm², a fill factor of 0.28, and an efficiency of 0.05 percent.

### Example 24

Example 1 was repeated, except that the dye salt used was the following:

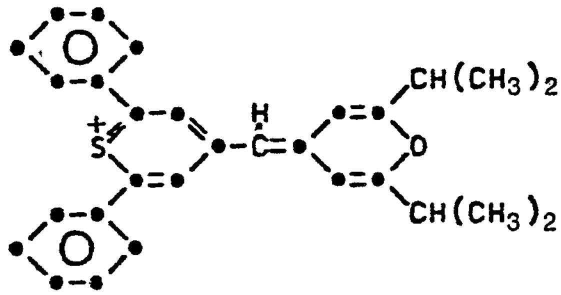

$ClO_4^-$

The element had an open-circuit voltage of 0.5 V, a short-circuit current of 0.24 mA/cm², a fill factor of 0.34, and a conversion efficiency of 0.05 percent.

### Examples 25 to 27

Elements were fabricated as described in Example 1, except that dye salts of the following structure were used:

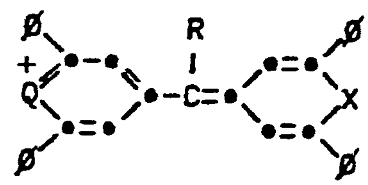

$ClO_4^-$

Table IV lists the output of these elements for various substitutions at Q, X, and R.

TABLE IV

| Example | Q | X | R | Open Circuit Voltage (volts) | Short Circuit Current mA/cm² | Conversion Efficiency, % |
|---|---|---|---|---|---|---|
| 25 | S | S | $—CH_3$ | 0.25 | 0.4 | 0.036 |
| 26 | O | O | —CN | 0.4 | 0.4 | 0.066 |
| 27 | O | O | 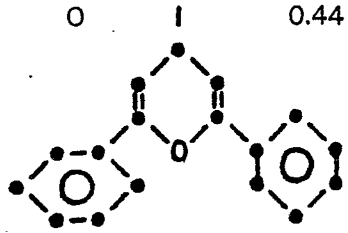 | 0.44 | 0.28 | 0.05 |

### Example 28

A photovoltaic element was prepared and tested as described in Example 1, except that the electron acceptor layer, at a thickness of 40 nm, was:

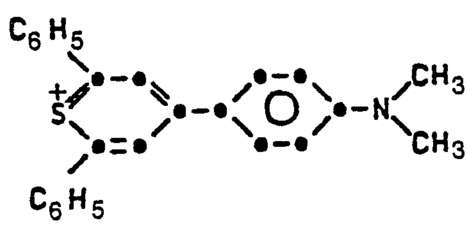

$ClO_4$

This element was found to have an open-circuit voltage of about 0.52 V, a short-circuit current of about 1 mA/cm², and a fill factor of 0.40, producing a conversion efficiency of about 0.27 percent.

Examples 29—36

A photovoltaic element was prepared and tested as described in Example 1, except that as the electron acceptor layer a compound of the structure:

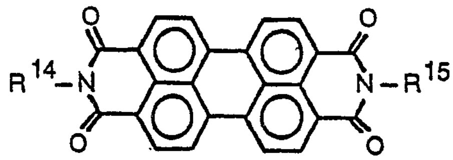

wherein $R^{14}$ and $R^{15}$ are as designated in Table V, was used in place of the photoconductive dye salt of Example 1, and a silver electrode was used in place of indium. Table V sets forth the resulting element properties.

TABLE V

| Example | $R^{14}$ and $R^{15}$ | Open-Circuit Voltage (mV) | Short-Circuit Current (mA/cm²) | Fill Factor | Conversion Efficiency (%) |
|---|---|---|---|---|---|
| 29 | $-CH_3$ | 385 | 1.93 | 0.55 | 0.55 |
| 30 | 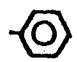 | 440 | 3.0 | 0.6 | 1.0 |
| 31 | 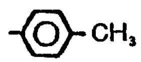 | 330 | 1.5 | 0.48 | 0.32 |
| 32 | 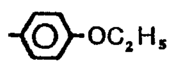 | 400 | 1.4 | 0.52 | 0.4 |
| 33 | H | 330 | 1.65 | 0.50 | 0.36 |
| 34 | 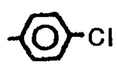 | 280 | 1.1 | 0.44 | 0.2 |
| 35 | 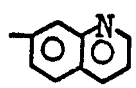 | 530 | 0.5 | 0.31 | 0.1 |
| 36 | $-CH_2CH_2CH_2-OH$ | 420 | 1.34 | 0.45 | 0.34 |

Examples 37—40

Photovoltaic elements were prepared and illuminated as described in Examples 29—36, except for the electron acceptor. The identity of each electron acceptor compound dyes and the results are given in Table VI.

TABLE VI

| Example | Electron Acceptor | Open-Circuit Voltage (mV) | Short-Circuit Current ($mA/cm^2$) | Fill Factor | Conversion Efficiency (%) |
|---|---|---|---|---|---|
| 37 | 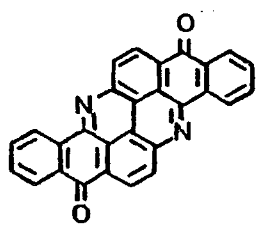 | 490 | 1.7 | 0.57 | 0.65 |
| 38 | 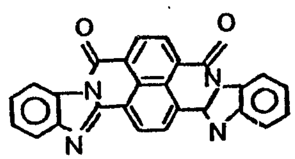 | 480 | 0.8 | 0.17 | 0.1 |
| 39 | 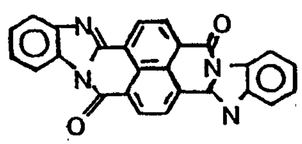 | 530 | 1.00 | 0.34 | 0.24 |

TABLE VI (Continued)

| Example | Electron Acceptor | Open-Circuit Voltage (mV) | Short-Circuit Current (mA /cm²) | Fill Factor | Conversion Efficiency (%) |
|---|---|---|---|---|---|
| 40 | 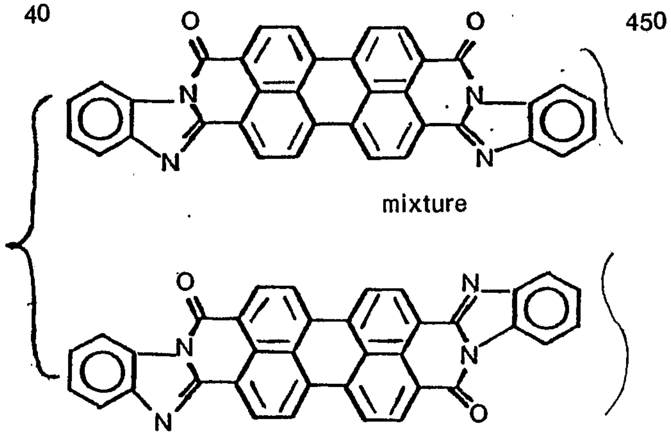 mixture | 450 | 1.7 | 0.61 | 0.66 |

Example 41

For this example, an element was prepared and tested, as described in Example 1, except that in place of copper-phthalocyanine, ovalene was used, silver was used in place of indium, and each of the electron donor and electron acceptor layers was 50 nm thick. The resulting element had a conversion efficiency of about 0.1 percent.

Example 42

An element was prepared and illuminated as described in Example 1, except that the electron donor was diindeno[1,2,3-cd-1′2′3′-lm]perylene and the electron acceptor was flavanthrone. The resulting element had an open-circuit voltage of 825 mV, a short-circuit current of 0.8 $mA/cm^2$, a fill factor of 0.51, and a conversion efficiency of 0.46 percent.

**Claims**

1. A photovoltaic element which comprises

(1) a first layer comprising an organic electron donor compound, in contact with
(2) a second layer comprising an organic electron acceptor compound,

said layers forming a rectifying junction between them and at least one of said layers being capable of absorbing radiation at wavelengths between 350 and 1000 nm, and

(3) an electrode in operative ohmic contact with each of said layers, at least one of said electrodes being transparent to electromagnetic radiation to which the photovoltaic element is sensitive,

characterised in that the organic compound of each of layers (1) and (2) has a molecule having a planar polycyclic nucleus and wherein the combined thickness of the electron donor compound layer or layers and the electron acceptor compound layer or layers is no greater than 0.5 micron.

2. A photovoltaic element as claimed in claim 1 in which both the electron donor and the electron acceptor compounds have a molecule whose surface area is at least 0.4 $nm^2$ and whose width is at least 0.5 nm.

3. A photovoltaic element as claimed in claim 1 or 2 in which the electron acceptor compound has a molecule containing a nucleus having at least 7 fused carbocyclic and/or heterocyclic rings and the electron donor compound has a molecule containing a nucleus having at least 8 fused carbocyclic and/or heterocyclic rings.

4. A photovoltaic element as claimed in claim 1 or 2 in which the electron donor is a porphyrin or phthalocyanine and the electron acceptor is a photoconductive organic dye capable of absorbing radiation at wavelengths between 350 and 1000 nm.

5. A photovoltaic element as claimed in claim 1, 2 or 4 in which the electron acceptor is a pyrylium, thiapyrylium or selenapyrylium dye salt.

6. A photovoltaic element as claimed in claim 5 in which the electron acceptor is a compound of the formula:

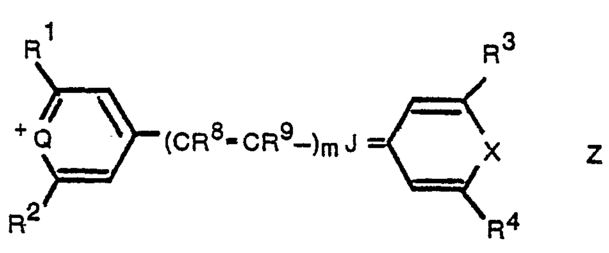

I

wherein

J is $CR^{10}$ or nitrogen,

Q and X are each oxygen, sulphur or selenium,

$R^8$, $R^9$ and $R^{10}$ are each hydrogen, an alkyl of 1—3 carbon atoms, an aryl, substituted aryl, cyano or nitro group,

$R^1$, $R^2$, $R^3$ and $R^4$ are each a phenyl or substituted phenyl group or an alkyl or alkoxy group of 1—5 carbon atoms, at least two of $R^1$, $R^2$, $R^3$ and $R^4$ being phenyl or substituted phenyl,

m is 0 or 1 and 0 if J is nitrogen, and

$Z^-$ is an anion.

7. A photovoltaic element as claimed in any of claims 1—4 in which the electron acceptor is a compound of the formula:

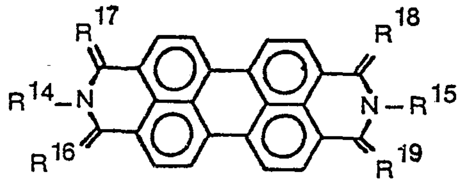

II

wherein
$R^{14}$ and $R^{15}$ are each hydrogen or an alkyl group of 1—5 carbon atoms which may be substituted, or a phenyl, substituted phenyl or quinolyl group, and
$R^{16}$, $R^{17}$, $R^{18}$ and $R^{19}$ are each oxygen, or $R^{14}$ and one of $R^{16}$ and $R^{17}$ and/or $R^{15}$ and one of $R^{18}$ and $R^{19}$ together complete a one or two ringed heterocyclic group, in which case the other of $R^{16}$ and $R^{17}$ and/or the other of $R^{18}$ and $R^{19}$ are oxygen.

8. A photovoltaic element as claimed in claim 7 in which the electron acceptor is the compound of the formula:

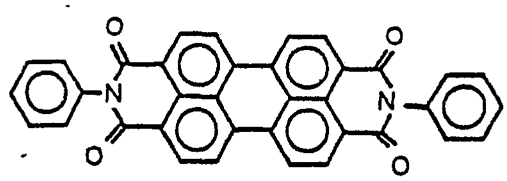

III

9. A photovoltaic element as claimed in any of claims 1—8 in which the electron donor is a compound of the formula:

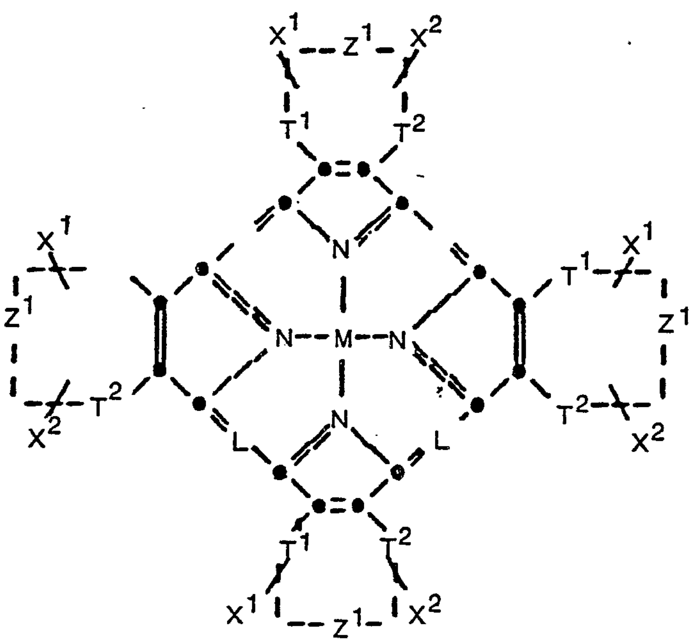

IV

wherein
L is CH or N,
M is a metal,
$T^1$ and $T^2$ are both S or both CH, or one of $T^1$ and $T^2$ is N and the other CH,
$X^1$ and $X^2$ are the same or different, and are each halogen or hydrogen; and
$Z^1$ represents the atoms necessary to complete an unsaturated ring having 6 ring atoms.

**Patentansprüche**

1. Photoelement mit

(1) einer ersten Schicht mit einer organischen Elektronendonorverbindung in Kontakt mit
(2) einer zweiten Schicht mit einer organischen Elektronenacceptorverbindung,

dessen Schichten zwischen sich einen Gleichrichterübergang bilden, wobei mindestens eine der Schichten Strahlung einer Wellenlänge zwischen 350 und 1000 nm zu absorbieren vermag und

(3) einer Elektrode in wirksamen Ohm'schen Kontakt mit jeder der Schichten, wobei mindestens eine der Elektroden für elektromagnetische Strahlung, der gegenüber das Photoelement empfindlich ist, durchlässig ist,

dadurch gekennzeichnet, daß die organische Verbindung jeder der Schichten (1) und (2) ein Molekül mit einem planaren polycyclischen Kern hat und daß die kombinierte Dicke der Elektronendonorverbindungsschicht oder -schichten und der Elektronenacceptorverbindungsschicht oder -schichten nicht größer als 0,5 Micron ist.

2. Photoelement nach Anspruch 1, in dem sowohl die Elektronendonor- als auch die Elektronenacceptorverbindung ein Molekül hat, dessen Oberfläche mindestens 0,4 $nm^2$ groß ist und dessen Breite mindestens 0,5 nm beträgt.

3. Photoelement nach Ansprüchen 1 oder 2, in dem die Elektronenacceptorverbindung ein Molekül mit einem Kern mit mindestens 7 kondensierten carbocyclischen und/oder heterocyclischen Ringen und die Elektronendonorverbindung ein Molekül mit einem Kern mit mindestens 8 kondensierten carbocyclischen und/oder heterocyclischen Ringen aufweist.

4. Photoelement nach Ansprüchen 1 oder 2, in dem der Elektronendonor ein Porphyrin oder Phthalocyanin und der Elektronenacceptor ein photoleitfähiger organischer Farbstoff, der Strahlung einer Wellenlänge zwischen 350 und 1000 nm zu absorbieren vermag, ist.

5. Photoelement nach Ansprüchen 1, 2 oder 4, in dem der Elektronenacceptor ein Pyrylium-, Thiapyrylium- oder Selenapyryliumfarbstoffsalz ist.

6. Photoelement nach Anspruch 5, in dem der Elektronenacceptor eine Verbindung der Formel:

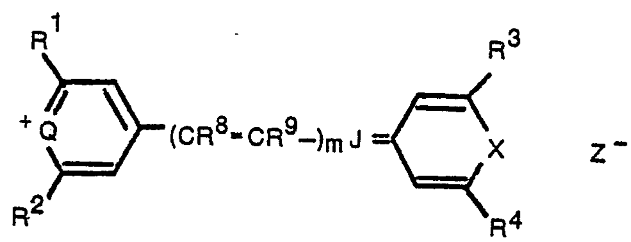

I

ist, worin bedeuten:

J = $CR^{10}$ oder Stickstoff,

Q und X jeweils Sauerstoff, Schwefel oder Selen,

$R^8$, $R^9$ und $R^{10}$ jeweils Wasserstoff, eine Alkylgruppe mit 1—3 Kohlenstoffatomen, eine Arylgruppe, eine substituierte Arylgruppe, eine Cyano- oder Nitrogruppe,

$R^1$, $R^2$, $R^3$ und $R^4$ jeweils eine Phenyl- oder substituierte Phenylgruppe oder eine Alkyl- oder Alkoxygruppe mit 1—5 Kohlenstoffatomen, wobei mindestens zwei der Gruppen $R^1$, $R^2$, $R^3$ und $R^4$ Phenyl- oder substituierte Phenylgruppen sind,

m = 0 oder 1 und 0, falls J Stickstoff ist und

$Z^-$ ein Anion.

7. Photoelement nach einem der Ansprüche 1—4, in dem der Elektronenacceptor eine Verbindung der Formel:

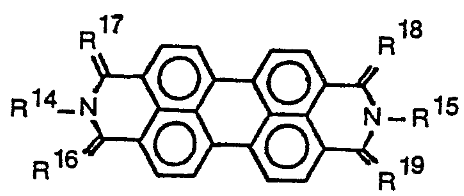

II

ist, worin bedeuten:

$R^{14}$ und $R^{15}$ jeweils Wasserstoff oder eine Alkylgruppe mit 1—5 Kohlenstoffatomen, die substituiert sein kann, oder eine Phenyl-, substituierte Phenyl- oder Chinolylgruppe und

$R^{16}$, $R^{17}$, $R^{18}$ und $R^{19}$ jeweils Sauerstoff, oder

$R^{14}$ und einer der Substituenten $R^{16}$ und $R^{17}$ und/oder

$R^{15}$ und einer der Substituenten $R^{18}$ und $R^{19}$ vervollständigen gemeinsam eine heterocyclische Gruppe mit ein oder zwei Ringen, in welchem Falle der andere der Substituenten $R^{16}$ und $R^{17}$ und/oder der andere der Substituenten $R^{18}$ und $R^{19}$ Sauerstoff darstellen.

8. Photoelement nach Anspruch 7, in dem der Elektronenacceptor eine Verbindung der folgenden Formel ist:

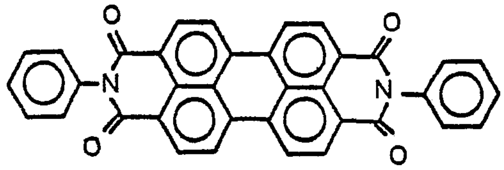

III

9. Photoelement nach einem der Ansprüche 1—8, in dem der Elektronendonor eine Verbindung der folgenden Formel ist:

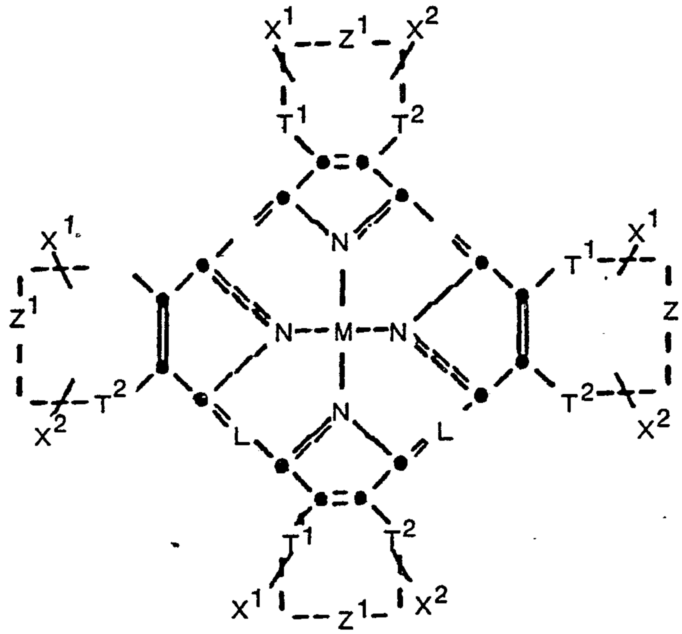

IV

worin bedeuten:
L = CH oder N,
M ein Metall,
$T^1$ und $T^2$ = beide S oder beie CH oder einer der Reste $T^1$ und $T^2$ ist N und der andere Rest ist CH,
$X^1$ und $X^2$, die gleich oder verschieden sind, stellen jeweils Halogen oder Wasserstoff dar und
$Z^1$ die Atome, die zur Vervollständigung eines ungesättigten Ringes mit 6 Ringatomen erforderlich sind.

## Revendications

1. Elément photovoltaïque qui comprend:

1) un première couche contenant un composé organique donneur d'électrons en contact avec
2) une deuxième couche contenant un composé organique accepteur d'électrons,

ces couches formant entre elles une jonction redresseuse et au moins l'une de ces couches pouvant absorber des radiations de longueurs d'onde comprises entre 350 nm et 1000 nm et

3) une électrode en contact ohmique effectif avec chacune de ces couches, au moins l'une de ces électrodes étant transparente au rayonnement électromagnétique auquel est sensible l'élément photovoltaïque,

caractérisé en ce que le composé organique de chacune des couches (1) et (2) a une molécule comprenant un noyau polycyclique plan et en ce que l'épaisseur totale de la couche ou des couches contenant le composé donneur d'électrons et de la couche ou des couches contenant le composé accepteur d'électrons est au plus égale à 0,5 $\mu m$.

2. Elément photovoltaïque conforme à la revendication 1, caractérisé en ce que les composés donneur et accepteur d'électrons ont une molécule dont la surface est d'au moins 0,4 $nm^2$ et dont la largeur est d'au moins 0,5 nm.

3. Elément photovoltaïque conforme à l'une des revendications 1 ou 2, caractérisé en ce que le composé accepteur d'électrons a une molécule contenant un noyau ayant au moins 7 cycles carbocycliques et/ou hétérocycliques accolés et le composé donneur d'électrons a une molécule contenant un noyau ayant au moins 8 cycles carbocycliques et/ou hétérocyclique accolés.

4. Elément photovoltaïque conforme à l'une des revendications 1 ou 2, caractérisé en ce que le composé donneur d'électrons est une porphyrine ou une phtalocyanine et le composé accepteur d'électrons est un colorant organique photoconducteur capable d'absorber des radiations de longueurs d'onde comprises entre 350 nm et 1000 nm.

5. Elément photovoltaïque conforme à l'une des revendications 1, 2, ou 4, caractérisé en ce que le composé accepteur d'électrons est un sel de pyrylium, de thiapyrylium ou de sélénapyrylium.

6. Elément photovoltaïque conforme à la revendication 5, caractérisé en ce que le composé accepteur d'électrons est un composé de formule:

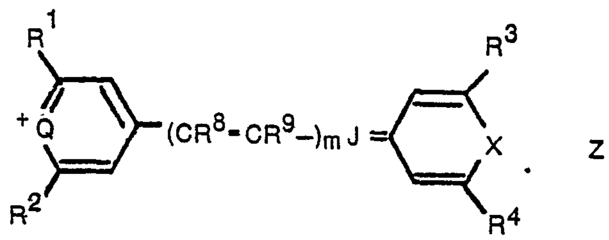

I

où

J est le groupe $CR^{10}$ ou un atome d'azote

Q et X représentent chacun un atome d'oxygène, de soufre ou de sélénium,

$R^8$, $R^9$ et $R^{10}$ représentent chacun un atome d'hydrogène, un radical alkyle de 1 à 3 atomes de carbone, un radical aryle, aryle substitué, cyano ou nitro,

$R^1$, $R^2$, $R^3$ et $R^4$ représentent chacun un radical phényle, phényle substitué ou un radical alkyle ou alkoxy de 1 à 5 atomes de carbone, au moins deux des symboles $R^1$, $R^2$, $R^3$ et $R^4$ étant des radicaux phényle substitué ou non,

m est égal à 1 ou 0 et m est égal à 0 si J est un atome d'azote, et

$Z^-$ est un anion.

7. Elément photovoltaïque conforme à l'une quelconque des revendications 1 à 4, caractérisé en ce que le composé accepteur d'électrons est un composé de formule:

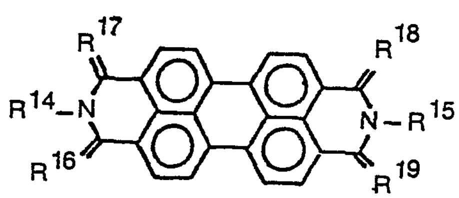

II

où

$R^{14}$ et $R^{15}$ représentent chacun un atome d'hydrogène ou un radical alkyle de 1 à 5 atomes de carbone qui peut être substitué, ou un groupe phényle, phényle substitué ou quinolyle, et

$R^{16}$, $R^{17}$, $R^{18}$ et $R^{19}$ représentent chacun un atome d'oxygène, ou bien $R^{14}$ et un des symboles $R^{16}$ et $R^{17}$ et/ou $R^{15}$ et un des symboles $R^{18}$ et $R^{19}$ forment ensemble un groupe hétérocyclique à un ou deux cycles et, dans ce cas, l'autre des symboles $R^{16}$ et $R^{17}$ et/ou l'autre des symboles $R^{18}$ et $R^{19}$ représente un atome d'oxygène.

8. Elément photovoltaïque conforme à la revendication 7, caractérisé en ce que le composé accepteur d'électrons est un composé de formule:

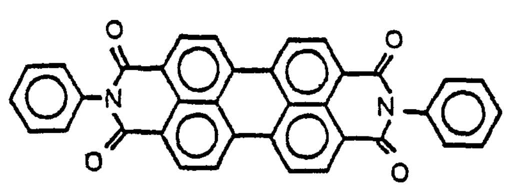

III

9. Elément photovoltaïque conforme à l'une quelconque des revendications 1 à 8, caractérisé en ce que le composé donneur d'électrons est un composé de formule:

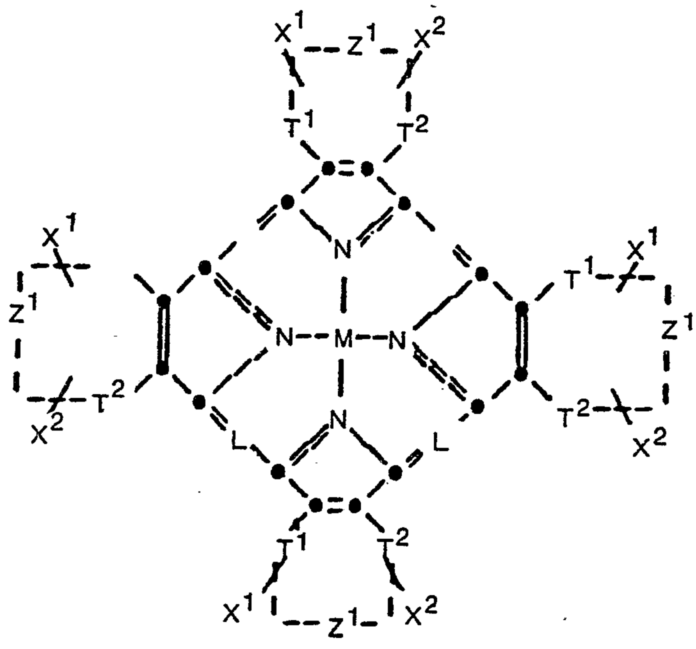

IV

où
L est le groupe CH ou un atome d'azote,
M est un métal,
$T^1$ et $T^2$ sont tous deux des atomes de soufre ou tous deux un groupe CH, ou bien l'un des symboles $T^1$ et $T^2$ est un atome d'azote, et l'autre le groupe CH,
$X^1$ et $X^2$ sont identiques ou différents et représentent chacun un atome d'halogène ou d'hydrogène,
$Z^1$ représente les atomes nécessaires pour compléter un cycle non saturé de 6 atomes.

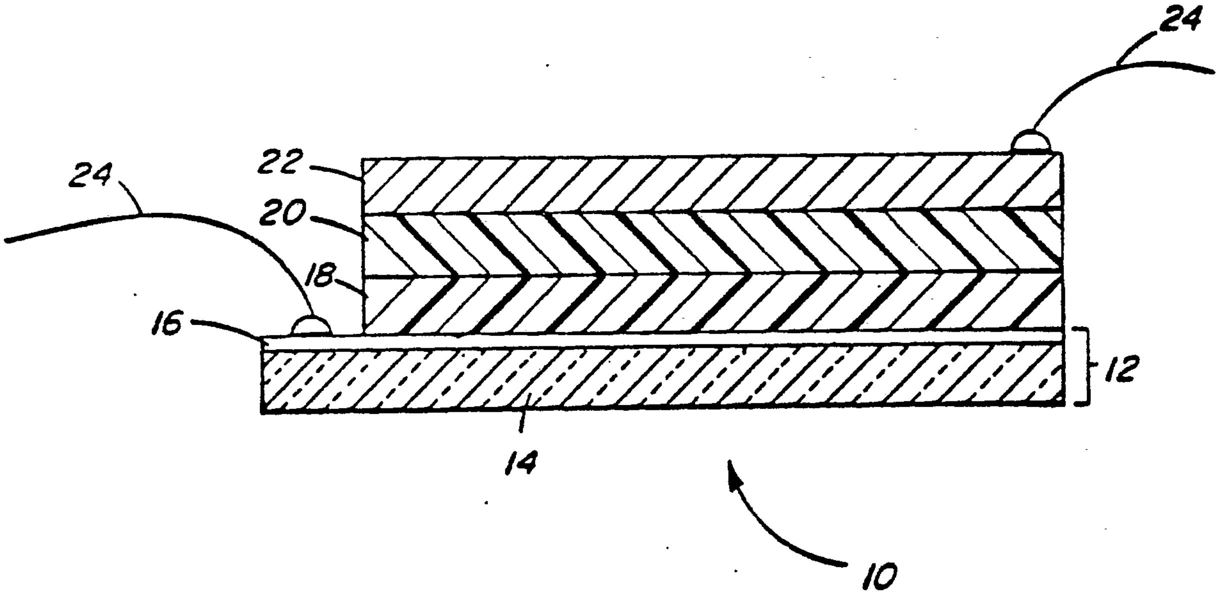
24
22
20
24
18
16
12
14
10